# EUROPEAN PATENT APPLICATION

(11) **EP 4 760 274 A1**
(43) Date of publication of application: **17.06.2026**
(21) Application number: 24219142.7
(22) Date of filing: 11.12.2024
(51) Int. Cl.: G01R 22/06

(54) **AN ELECTRICITY METER**

(71) Applicant: Aidon Oy, 40100 Jyväskylä (FI)
(72) Inventor: Sievänen, Aleksi, 40100 Jyväskylä (FI); Lohvansuu, Juha, 40100 Jyväskylä (FI)
(74) Representative: Berggren Oy

(57) **Abstract**

The invention relates to an electricity meter. It comprises terminals (2) for inlet and outlet power cables. The terminals comprise screws (3) for attaching the power cables. The electricity meter comprises also a terminal module (4) comprising said terminals inside. The terminal module has a front plate having holes (6) in order to insert temperature sensors near the screws.

## Description

### Field of technology

The invention relates to electricity meters which are designed to meter power consumption of a house/real estate, and other possible information.

### Prior art

An electricity meter is used to measure power consumption of a house/real estate, and other possible information. The electricity meter is located in a metering board, wherein the power is delivered through cables from a power distribution network. In practice the electricity meter is connected to the cables from the power distribution network by using inlet cables and possible rails.

From the metering board the power is delivered to the house/real estate through outlet cables (and possible rails) and supply cables. The supply cables are power cables between the metering board and distribution board/s of the house/real estate.

The installation of the electricity meter is a demanding task for an installer, and he/she has to secure in multiple ways reliable connections of wires/cables. If the wires/cables are not tightened enough, the connection is overheating, and plastic isolation may even smelt. Fire is possible before a direct short circuit between phases breaks the fuse. It is also possible that the wires/cables can loose also during lifetime when material expansion due the temperature differences cause a loose connection.

### Short description

The object of the invention is to alleviate the problems said above. The object is achieved in a way described in the independent claim. Dependent claims illustrate different embodiments of the invention.

An electricity meter according to the invention comprises terminals for inlet and outlet power cables. Each terminal comprises a screw to attach one of the cables. The electricity meter comprises also a terminal module comprising said terminals inside. The terminals are arranged so that the inlet and the outlet cables for each phase are next to each other. The terminal module has a front plate having holes. The electricity meter further comprises a circuit board module, which comprises metering electronics. The circuit board module is attached to the terminal module. The circuit board module comprises also temperature sensors, which stand out of the circuit board, so that the temperature sensors are in the terminal module via the holes. The temperature sensors are arranged so that, for each phase, one of the temperature sensors is near the screws of the terminals of the inlet and the outlet cables of one of the phases. Thus, the temperature sensors are arranged to measure temperatures near the screws of the terminals of the inlet and the outlet cables of each phase.

### List of figures

In the following, the invention is described in more detail by reference to the enclosed drawings, where
- Figure 1: illustrates an example of an electricity meter according to the invention,
- Figure 2: illustrates the example of figure 1 with a cover,
- Figure 3: illustrates an example of a terminal module,
- Figure 4: illustrates an example of a circuit board module, which is connected to the terminal module,
- Figure 5: illustrates another view of a terminal module according to the invention, and
- Figure 6: illustrates an example of curves showing ratios between temperature and current.

### Description of the invention

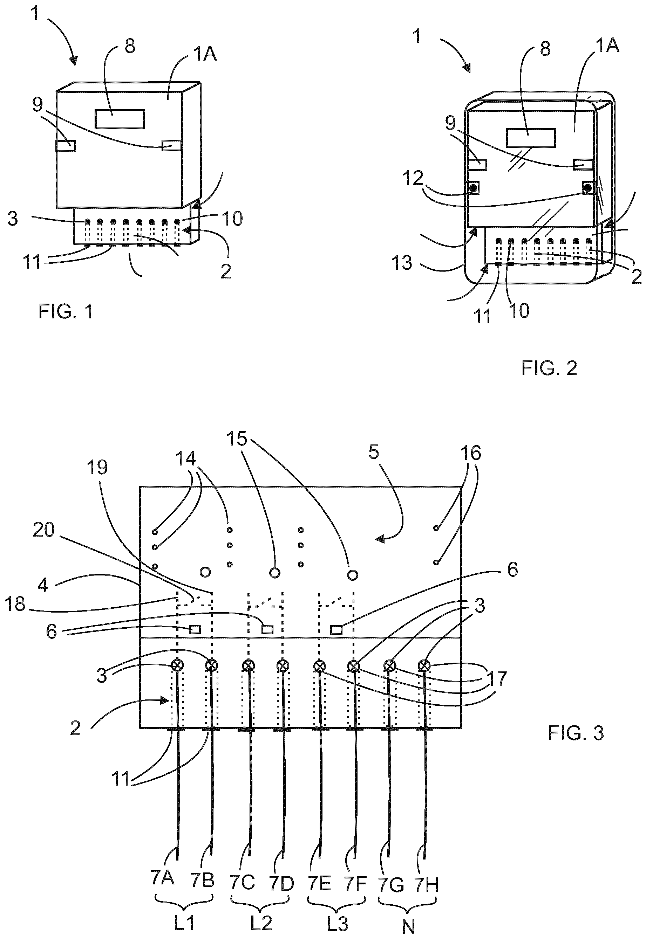

Figure 1 shows an example of an electricity meter 1 according to the invention without a cover 13. Figure 2 illustrates the example of figure 1 with the cover.

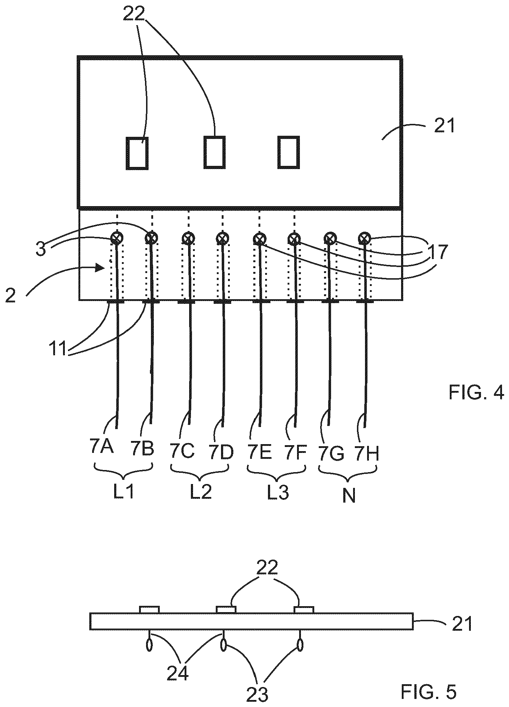

An electricity meter 1 according to the invention comprises terminals 2 for inlet and outlet power cables 7A, 7B, 7C, 7D, 7E 7F, 7G, 7H. The inlet cables and outlet cables are illustrated in figures 3 and 4. Each terminal comprises a screw 3 to attach one of the cables.

The electricity meter 1 comprises also a terminal module 4 comprising said terminals 2 inside. The terminals are arranged so that the inlet and the outlet cables7A, 7B, 7C, 7D, 7E 7F, 7G, 7H for each phase L1, L2. L3 are next to each other (figure 3). The terminal module 4 has a front plate 5 having holes 6. As known a power distribution system typically has three phases, and the power delivered by of the phases is measured by an electricity meter. Each phase has it's own wire/cable. More precisely the phase means a voltage phase in the wire/cable. The phases L1, L2, L3 are different from each other.

The electricity meter further comprises a circuit board module 21, which comprises metering electronics (figures 4 and 5). The circuit board module is attached to the terminal module 4. The circuit board module comprises also temperature sensors 23, which stand out of the circuit board, so that the temperature sensors are in the terminal module 4 via the holes 6. The temperature sensors are arranged so that, for each phase L1, L2, L3, one of the temperature sensors is near the screws 3 of the terminals of the inlet and the outlet cables of one of the phases. Thus, the temperature sensors 23 are arranged to measure temperatures near the screws 3 of the terminals 2 of the inlet and the outlet cables of each phase.

The electricity meter 1 has typically a display 8 and control buttons 9. The meter has a casing 1A, which covers the circuit board/s and therefore the metering electronic. Figure 2 shows a removable cover 13, which comprise holes at least for the control button/s. The removeable cover and the electricity meter comprise fasteners 12 which can be sealed. In the embodiment of figure 2 the removeable cover 13 covers the terminals 2 for the inlet and outlet power cables, and also the metering electronic with the casing 1A. However, it is also possible that the removeable cover covers the terminals 2 but not the whole meter 1. The removeable cover is transparent in figure 2, but it can also be non-transparent. As can be noted the removeable cover can be realized in different ways.

Figure 3 shows an example of the terminal module 4. Figures 4 and 5 illustrate an example of the circuit board module 21. The terminals 2 (the bodies of the terminals), for the cables comprise the screws 3 to attach the cables, and openings 11 to insert the ends of the cables into the terminals. As said, the terminals are arranged so that the inlet and the outlet cables 7A, 7B, 7C, 7D, 7E 7F, 7G, 7H for each phase L1, L2. L3 are next to each other. In this embodiment the inlet cables are referred to as 7A, 7C, and 7E. 7G and 7H refer to the inlet and outlet cables of neutral potential. The outlet cables are referred to as 7B, 7D, 7F. A pair of the inlet cable 7A and 7B belongs to the phase L1 of the three-phase power line. A pair of the inlet cable 7C and 7D belongs to the phase L2 of the three-phase power line. A pair of the inlet cable 7E and 7F belongs to the phase L3 of the three-phase power line.

As said, the holes 6 are on the front plate 5. Figure 3 shows also connections 14, 15, 16 in order to attach a circuit board module 21 on the terminal module 4. In this embodiment the front plate 5 of the terminal module 4 has second holes 17 for the screws 3.

The electricity meter 1 is arranged to measure current of each phase L1, L2, L3, and also average current of each phase and average temperature from each temperature sensor. The electricity meter is also arranged to monitor temperature/current ratios of each phase, and also arranged to send an alarm signal if at least one of the ratios is too high. So, if the measured temperature is too high with respect to the current of the phase L1, L2 or L3, it indicates that the inlet cable, the outlet cable or the both cables are not tightened enough by the screws, and the connection/s is overheating. Loosening of the screw connection may happen during lifetime when material expands and shrinks due the temperature differences.

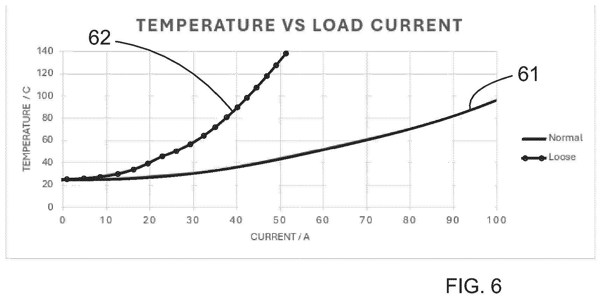

Figure 6 shows an example of a diagram showing a current (ampere) through a connection (i.e. the screw 3 connection of the terminal 2 in a horizontal axis and the temperature (Celsius) measured near the screw connection in a vertical axis. A plain solid line 61 shows a curve for a normal tight connection, and a curve 62 with circuits is an example of a loose connection. As can be seen the ratio between the measured temperature and the current can indicate whether the screw connection is loose or not. In the example of figure 6 the curve 61 indicates the ratios of the measured temperatures and measured currents in normal conditions. If the ratio is higher, it is likely that the screw connection is loose. The temperature of a loose connection can be so high (like 140 Celsius) that plastic material of the terminal and other elements near the connection can smelt. In addition, higher temperatures of a loose connection decrease lifetime of components and elements near the connection.

Regarding the example of figure 6, the measured temperature is 25 Celsius when the current is 30 A for a normal tight connection, and the ratio of temperature/current is 0,833. If the ratio from the measured values is higher, it indicates that the connection is somehow loose. The curve 62 is an example and one possible case for a loose connection having the ratio 2 at 30 A. Similarly, ratios for all points in the normal condition curve 61 can be calculated and compared to the ratios calculated from the measurements.

To be sure that a screw connection is loose, average temperatures and currents can be used for calculating the temperature/current ratio. A period for calculating the average values of the temperature and current can, for example, be one hour. However, the magnitude of the current through the connection can have an effect on the duration of the period, which is used for calculating average values. The higher the current is the shorter the duration of the period is. In addition, the ambient temperature can be taken into account when calculating the ratios or when forming a temperature/current curve for a normal condition of the connection. Further, another way to be sure that a screw connection is loose, is to follow during a certain period, like half an hour, or one hour, that the ratios from the measured values remain over the normal ratio/s of the temperature and the current. The temperature values and the current values and therefore also the ratios 61 for a normal tight connection, i.e. the screw connection, can be achieved beforehand and these values can be in the memory/memories of the electricity meter 1 in order to compare them with the ratios achieved/calculated from the measurements.

So, in other words, the electricity meter 1 is arranged to measure current of each phase L1, L2, L3, and also arranged to calculate and monitor temperature/current ratios of each phase. The electricity meter is also arranged to send an alarm signal if at least one of the ratios is too high. One way to make the calculations is that the electricity meter 1 is arranged to calculate average current of each phase L1, L2, L3, and average temperature from each temperature sensor 23, and the electricity meter is also arranged to calculate and monitor average temperature/current ratios of each phase, and and further arranged to send an alarm signal if at least one of the ratios is too high.

Another way to make the calculations is that the electricity meter 1 is arranged to measure current of each phase L1, L2, L3, the electricity meter being also arranged to calculate and monitor temperature/current ratios of each phase, and further arranged to send an alarm signal if at least one of the ratios remains too high during a certain time period.

The ratios 61 for a normal tight screw connection can be in a memory/memories of the electricity meter 1 in order to compare them with the ratios calculated from the measurements. The calculated ratio/s is too high if it is greater than the ratio/s of the normal tight screw connection.

The alarm signal can be sent to a maintenance personnel through a communication device of the electricity meter 1. So, the electricity meter comprises the communication device like a wireless modem or a communication port module. Therefore, the maintenance personnel can react relatively quickly to the loosing of the connections, before any larger damages, like fire, happen, and check and repair the connections.

Figure 4 shows a schematic example of the circuit board module 21 connected to the terminal module using said connections 14, 15, 16. The circuit board module 21 comprises one circuit board or two circuit boards connected to each other. The use of two circuit boards can be convenient so that one circuit board is for analog circuits and the other circuit is for digital circuits. Figure 1 shows schematically only one circuit board above having different components 22 (like processors, memories, capacitors etc..) providing the metering electronics. Figure 5 shows a side view of the circuit board module/ circuit board 21 illustrating also temperature sensors 23, which stand out of the circuit board/circuit board module. The temperature sensors are placed via the holes 6 (figure 3) so that they are in the terminal module 4. The temperature sensors can be in connection with the circuit board/circuit board module through a connection wire 24. By using the connection wires the temperature sensors can be located at suitable places inside the terminal module. As said, the circuit board makes calculations from the measurement, and it has the ratio values of normal screw connections (normal tight crew connections) in its memory/memories. So, the circuit board module also compares the normal ratio value to the calculated ratio values from the measurements as described above.

As said, there is one temperature sensor per phase L1, L2, L3. The temperature sensor is near the screws 3 of the terminals of the inlet and the outlet cables of one of the phases, like cables 7C, 7D of phase L2, or cables 7E, 7F of phase L3. Therefore, the temperature sensors 23 are arranged to measure temperatures near the screws 3 of the terminals 2 of the inlet and the outlet cables of each phase. The circuit board module 21 makes calculations from the measurements.

Figure 3 illustrates also that the terminal module 4 comprises a switch 20 for each phase L1, L2, L3 between connection elements 18, 19 of the phase specific terminals. The connection elements connect the inlet cables and outlet cables to the circuit board module 21 (illustrated schematically in figure 3). The switches are controllable switches, so they can be disconnected, for example when the supply lines to the house are desired to be in power-off condition.

As can be seen the invention can be realized in many ways. It is evident from the above that the invention is not limited to the embodiments described in this text but can be implemented in many other different embodiments within the scope of the independent claims.

## Claims

1. An electricity meter (1) comprising terminals (2) for inlet and outlet power cables (7A, 7B, 7C, 7D, 7E 7F, 7G, 7H), each terminal comprising a screw (3) to attach one of the cables, **characterised in that**
the electricity meter (1) comprises a terminal module (4) comprising said terminals (2) inside, the terminals being arranged so that the inlet and the outlet cables (7A, 7B, 7C, 7D, 7E 7F, 7G, 7H) for each phase (L1, L2, L3) are next to each other, and the terminal module (4) has a front plate (5) having holes (6),
the electricity meter further comprising a circuit board module (21), comprising metering electronics, the circuit board module being attached to the terminal module (4), and the circuit board module comprising temperature sensors (23) which stand out of the circuit board module, so that the temperature sensors are in the terminal module (4) via the holes (6), the temperature sensors being arranged so that, for each phase (L1, L2, L3), one of the temperature sensors is near the screws (3) of the terminals of the inlet and the outlet cables of one of the phases, the temperature sensors (23) being arranged to measure temperatures near the screws (3) of the terminals (2) of the inlet and the outlet cables of each phase.

2. An electricity meter according to claim 1, **characterised in that** the electricity meter (1) is arranged to measure current of each phase (L1, L2, L3), the electricity meter being also arranged to calculate and monitor temperature/current ratios of each phase, and also arranged to send an alarm signal if at least one of the ratios is too high.

3. An electricity meter according to claim 2, **characterised in that** the electricity meter (1) is arranged to calculate average current of each phase (L1, L2, L3), and average temperature from each temperature sensor (23), the electricity meter being also arranged to calculate and monitor average temperature/current ratios of each phase, and also arranged to send an alarm signal if at least one of the ratios is too high.

4. An electricity meter according to claim 2, **characterised in that** the electricity meter (1) is arranged to measure current of each phase (L1, L2, L3), the electricity meter being also arranged to calculate and monitor temperature/current ratios of each phase, and also arranged to send an alarm signal if at least one of the ratios remains too high during a certain time period.

5. An electricity meter according to claim 2, 3, or 4, **characterised in that** the ratios (61) for a normal tight screw connection are in a memory/memories of the electricity meter (1) in order to compare them with the ratios calculated from the measurements, the calculated ratio/s being too high if it is greater than the ratio/s of the normal tight screw connection.

6. An electricity meter according to claim 2, 3, 4 or 5, **characterised in that** the front plate (5) of the terminal module (4) has second holes (17) for the screws.

7. An electricity meter according to claim 1, 2, 3, 4, 5 or 6, **characterised in that** the circuit board module (21) comprises one circuit board or two circuit boards connected to each other.

8. An electricity meter according to claim 7, **characterised in that** the terminal module (4) comprises a switch (20) for each phase (L1, L2, L3) between connection elements (18, 19) of the phase specific terminals.
